# EUROPÄISCHE PATENTSCHRIFT

(11) **EP 3 844 513 B1**
(45) Veröffentlichungstag und Bekanntmachung des Hinweises auf die Patenterteilung: **01.10.2025**
(21) Anmeldenummer: 19739982.7
(22) Anmeldetag: 12.07.2019
(51) Int. Cl.: G01R 31/389, G01R 31/396, H01M 10/48, H01M 10/42

(54) **VERFAHREN ZUM ERKENNEN VON KONTAKTIERUNGSFEHLERN IN EINEM AKKUPACK UND SYSTEM ZUM DURCHFÜHREN DES VERFAHRENS**
METHOD FOR IDENTIFYING CONTACT FAULTS IN A BATTERY PACK, AND SYSTEM FOR CARRYING OUT SAID METHOD
PROCÉDÉ DE DÉTECTION DE DÉFAUTS DE CONTACT DANS UN BLOC D'ACCUMULATEURS ET SYSTÈME DE MISE EN OEUVRE DU PROCÉDÉ

(30) Priorität: 29.08.2018 DE 102018214612
(43) Veröffentlichungstag der Anmeldung: 07.07.2021
(73) Patentinhaber: Robert Bosch GmbH, 70442 Stuttgart (DE)
(72) Erfinder: ROEDER, Patrick, 71083 Herrenberg (DE); KLEE, Christoph, 70599 Stuttgart (DE); SEIBERT, Marc-Alexandre, 70567 Stuttgart (DE)
(86) Internationale Anmeldenummer: PCT/EP2019/068816
(87) Internationale Veröffentlichungsnummer: WO 2020/043385

(56) Entgegenhaltungen:
- EP-A1- 1 758 226
- EP-A1- 1 758 226
- WO-A1-90/10334
- DE-A1- 102014 221 272
- US-A1- 2004 212 350
- US-A1- 2004 212 350
- US-A1- 2013 063 094
- US-A1- 2016 301 224
- US-A1- 2016 301 224

## Beschreibung

Die vorliegende Erfindung betrifft ein Verfahren zum Erkennen von Kontaktierungsfehlern in einem Akkupack und einen Akkupack mit einer Mehrzahl von Ackus.

Ein elektrisches Gerät wird häufig mit mehrfach verwendbaren Akkus betrieben, die im elektrischen Gerät entladen und mit einem Ladegerät wieder geladen werden können. Dabei ist es üblich, eine Mehrzahl von Akkus zu einem Akkupack zu verschalten. Das Verschalten der Akkus kann mittels Zellverbindern erfolgen. Diese bestehen aus Metall und werden typischerweise an die Akkus angeschweißt.

Ein Akkupack muss innerhalb eines bestimmten Spezifikationsfensters betrieben werden, das beispielsweise eine Temperatur, einen Ladestrom, einen Entladestrom und eine Ladespannung betrifft. Beispielsweise wird die Ladespannung eines einzelnen Akkus oder einer Mehrzahl parallel miteinander verschalteter Ackus gemäß der Norm IEC 62841 überwacht, um sicherzustellen, dass das Laden nicht mit einer zu hohen Ladespannung erfolgt. Auch muss beim Entladen eines Akkus sichergestellt werden, dass eine bestimmte Entladeschlussspannung nicht unterschritten wird, was den Akku dauerhaft beschädigen könnte.

Beim Einsatz elektrischer Geräte können mechanische Belastungen und Vibrationen auftreten, die die Zellverbinder und/oder deren Schweißstellen beschädigen können. Löst sich in Folge dessen ein Akku elektrisch aus dem Verbund der Ackus, kann es beispielsweise sein, dass sich der Strom auf eine reduzierte Anzahl von Akkus verteilt. Dadurch kann es sein, dass die verbliebenen Akkus außerhalb ihres Spezifikationsfensters betrieben werden. Dies kann wiederum zu einer Beschädigung der verbliebenen Akkus und gegebenenfalls zu einer Gefährdung infolge der Beschädigung führen. Außerdem besteht die Gefahr, dass es im Fall einer beschädigten Schweißstelle zu einer schädlichen Überhitzung kommen kann. Ursache hierfür ist eine hochohmige Kontaktierung zwischen einem Akku und einem Zellverbinder infolge der geschädigten Schweißstelle.

Aus der Offenlegungsschrift DE 10 2017 115 785 A1 ist eine Spannungsmessvorrichtung zum Messen einer Spannung einer Batterie bekannt. Die Spannungsmessvorrichtung weist ein Spannungsmessmodul, einen Schutzschaltkreis, einen Entladeschaltkreis und Tiefpassfilter auf. Der Schutzschaltkreis ist zwischen der Batterie und dem Entladeschaltkreis und zwischen der Batterie und den Tiefpassfiltern angeordnet. Das Spannungsmessmodul misst eine erste Spannung, die zwischen zwei Tiefpassfiltern anliegt, und eine zweite Spannung, die zwischen zwei Anschlüssen des Entladeschaltkreises anliegt. Die erste Spannung entspricht einer an der Batterie anliegenden Spannung vermindert um einen Innenwiderstand des Schutzschaltkreises. Die zweite Spannung ist eine Korrekturspannung. Aus den gemessenen Spannungen kann die tatsächlich an der Batterie anliegende Spannung ermittelt werden. Weist die an der Batterie anliegende Spannung einen ungewöhnlichen Wert auf, wird ein Sicherheitsmechanismus aktiviert.

Aus der europäischen Patentanmeldung EP 3 035 067 A1 ist ein Verfahren zum Erkennen von Kontaktierungsfehlern in einem Batteriepack bekannt. Ein Spannungsunterschiedsdetektor misst eine Spannung, die zwischen einem Zellverbinder und einem Kommunikationskabel zur Kommunikation von Sender/Empfänger-Einheiten anliegt. Ermittelt der Spannungsunterschiedsdetektor eine Spannung, die über einem Schwellwert liegt, wird von einem fehlerhaften Zellverbinder ausgegangen. Ein entsprechender Schaltkreis für einen Akkupack bzw. ein entsprechendes Verfahren gehen auch aus der WO 90/10334 A 1 hervor.

Die DE 10 2014 221272 A1 offenbart ein Verfahren zur Überwachung einer Batterie, wobei die Batterie mehrere Zellverbunde mit mehreren miteinander parallel verschalteten Batteriezellen aufweist. Die Zellverbunde sind durch elektrische Zellverbinder miteinander verbunden, und ein oder mehrere Temperatursensoren sind zwischen den Zellverbunden angeordnet. Wenn ein Spannungsabfall über einer oder mehreren der Batteriezellen an den elektrischen Zellverbindern größer als ein vorgegebener Wert ist und gleichzeitig an zumindest einem der Temperatursensoren eine Temperatur auftritt, welche eine vorgegebene Temperatur übersteigt, wird ein Fehlersignal ausgegeben. Die fehlerhafte Batteriezelle kann dann von dem Zellverbund getrennt werden.

Aus der US 2013/063094 A1 ist ferner ein Verfahren zum Erkennen von Kontaktierungsfehlern in einem Akkupack mit folgenden Schritten bekannt:
- Anlegen zumindest eines Stroms an den Akkupack.
- Ermitteln zumindest einer am Akkupack anliegenden Spannung in Abhängigkeit vom angelegten Strom.
- Bestimmen zumindest eines Parameters auf Grundlage der ermittelten Spannung.
- Vergleichen des Parameters mit einer Vergleichsgröße.

Eine Aufgabe der vorliegenden Erfindung ist es, ein Verfahren zum Erkennen von Kontaktierungsfehlern in einem Akkupack anzugeben und einen entsprechenden Akkupack, bereitzustellen. Diese Aufgabe wird durch ein Verfahren zum Erkennen von Kontaktierungsfehlern in einem Akkupack und einen entsprechende Akkupack mit den Merkmalen der unabhängigen Ansprüche gelöst. Vorteilhafte Weiterbildungen sind in abhängigen Ansprüchen angegeben.

Ein Verfahren zum Erkennen von Kontaktierungsfehlern in einem Akkupack, wobei jeder Akku des Akkupacks zumindest mit einem weiteren Akku des Akkupacks parallel geschaltet ist, weist folgende Verfahrensschritte auf:
- Anlegen zumindest eines Stroms an den Akkupack.
- Ermitteln zumindest einer am Akkupack anliegenden Spannung in Abhängigkeit vom angelegten Strom.
- Bestimmen zumindest eines Parameters auf Grundlage der ermittelten Spannung.
- Vergleichen des Parameters mit einer Vergleichsgröße.
- Sperren des Akkupacks, wenn der Parameter um einen festgelegten Schwellwert von der Vergleichsgröße abweicht, wobei das Sperren des Ackupacks dadurch erfolgt, dass ein Temperatursensor des Akkupacks derart beeinflusst wird, dass eine Temperatur des Akkupacks außerhalb eines zulässigen Betriebstemperaturbereichs des Akkupacks erfasst wird und eine weitere Verwendung des Akkupacks von einer Steuerung verhindert wird.

Der angelegte Strom kann ein Ladestrom oder ein Entladestrom sein. Der Ladestrom kann von einem als Ladegerät ausgebildeten elektrischen Werkzeug bereitgestellt werden. Der Entladestrom kann von einem elektrischen Gerät, das beispielsweise als Werkzeug ausgebildet ist, verbraucht werden. Die Tatsache, dass jeder Akku des Akkupacks zumindest mit einem weiteren Akku des Akkupacks parallel geschaltet ist, bedeutet, dass der Akkupack zumindest zwei Akkus aufweist, die parallel geschaltet sind. Somit weist der Akkupack zumindest zwei Stränge auf, auf die sich ein Strom verteilen kann. Löst sich ein Akku eines Stranges elektrisch aus dem Verbund der Akkus, kann sich die Anzahl der Stränge des Akkupacks verringern. Dadurch kann es sein, dass über die verbliebenen Stränge ein erhöhter Strom fließt. Dieser erhöhte Strom kann gegebenenfalls außerhalb eines zulässigen Stromwertebereichs für den weniger-strängigen Akkupack liegen. Dadurch kann es zu einer Beschädigung der Akkus in den verbliebenen Strängen kommen. Vorteilhafterweise ermöglicht das Verfahren das Erkennen von Kontaktierungsfehlern in einem mehrsträngigen Akkupack. Dies erlaubt es, Maßnahmen zu ergreifen, die den Akkupack vor einer Beschädigung bewahren.

Vorteilhafterweise kann eine Beschädigung des Akkupacks durch das Sperren des Akkupacks verhindert werden, wenn der Akkupack beispielsweise nicht mehr innerhalb seines Spezifikationsfensters betrieben werden kann, nachdem sich ein Akku des Akkupacks elektrisch aus dem Verbund gelöst hat. Ein permanentes Sperren des Akkupacks ist beispielsweise auch dann vorteilhaft, wenn unstete Kontaktierungsfehler vorliegen. Beispielsweise kann es sein, dass bei einer zerrütteten Schweißstelle noch kraftschlüssiger Kontakt zwischen einem Zellverbinder und einem Akku des Akkupacks besteht, der jedoch nicht zuverlässig ist. Die Steuerung kann beispielsweise ein Microcontroller eines elektrischen Geräts oder ein Microcontroller des Akkupacks sein.

In einer Ausführungsform ist der Temperatursensor als Thermistor ausgebildet. Das Beeinflussen des Temperatursensors im Rahmen des Sperrens des Akkupacks erfolgt dadurch, dass eine mit dem Temperatursensor in Reihe geschaltete Sicherung mit einer für die Sicherung überkritischen Spannung beaufschlagt wird.

In einer Ausführungsform ist der Temperatursensor als Thermistor ausgebildet. Das Beeinflussen des Temperatursensors im Rahmen des Sperrens des Akkupacks erfolgt dadurch, dass ein mit dem Temperatursensor in Reihe geschalteter erster Schalter geöffnet wird.

Die Variante zum Sperren des Akkupacks, bei der der Temperatursensor durch Öffnen des ersten Schalters beeinflusst wird, bietet den Vorteil, dass ein Entsperren des Akkupacks auf einfache Weise erfolgen kann, ohne dass eine Sicherung ausgetauscht werden muss.

In einer Ausführungsform weist das Verfahren folgenden weiteren Verfahrensschritt auf: Der Akkupack wird entsperrt. Das Entsperren des Akkupacks erfolgt dadurch, dass der Temperatursensor derart beeinflusst wird, dass eine Temperatur des Akkupacks innerhalb des zulässigen Betriebstemperaturbereichs des Ackupacks erfasst wird und die weitere Verwendung des Akkupacks von der Steuerung ermöglicht wird. Das Entsperren des Akkupacks ist beispielsweise dann sinnvoll, wenn sich ein Akku des Akkupacks elektrisch aus dem Verbund gelöst hat, sodass der Akkupack weniger Stränge aufweist aber die weitere Verwendung des Akkupacks noch möglich ist. Die weitere Verwendung des weniger-strängigen Akkupacks kann beispielsweise mit einem reduzierten Ladestrom erfolgen.

In einer Ausführungsform erfolgt das Beeinflussen des Temperatursensors im Rahmen des Entsperrens des Akkupacks durch Schließen des ersten Schalters.

Ein Akkupack weist eine Mehrzahl von Akkus auf. Jeder Akku des Akkupacks ist zumindest mit einem weiteren Akku des Akkupacks parallel geschaltet. Der Ackupack weist einen ersten Anschluss und einen zweiten Anschluss zum Verbinden des Akkupacks mit einem elektrischen Gerät auf. Der Akkupack weist zumindest ein Spannungsmessgerät, eine erste Steuerung, einen Speicher und einen Temperatursensor auf. Die erste Steuerung weist einen dritten Anschluss zum Verbinden der ersten Steuerung mit einer zweiten Steuerung auf. Die erste Steuerung ist mit dem Spannungsmessgerät und mit dem Speicher verbunden. Der Temperatursensor ist dazu vorgesehen, eine Temperatur des Akkupacks zu erfassen. Der Temperatursensor weist einen vierten Anschluss zum Verbinden des Temperatursensors mit der ersten Steuerung oder mit der zweiten Steuerung auf. Das Spannungsmessgerät ist dazu ausgebildet, eine am Akkupack anliegende Spannung zu erfassen. Der Temperatursensor ist dazu vorgesehen, derart beeinflusst zu werden, dass eine Temperatur des Akkupacks außerhalb eines zulässigen Betriebstemperaturbereichs des Akkupacks erfasst wird und eine weitere Verwendung des Akkupacks von der zweiten Steuerung verhindert wird, wodurch der Akkupack gesperrt werden kann.

In einer Ausführungsform ist der Temperatursensor als Thermistor ausgebildet. Der Akkupack weist eine mit dem Thermistor in Reihe geschaltete Sicherung auf. Die Sicherung ist mit dem ersten oder mit dem zweiten Anschluss verbunden. Die mit dem Thermistor in Reihe geschaltete Sicherung ermöglicht es, dass der Thermistor in einem unterbrochenen Zustand der Sicherung hochohmig ist. Vorteilhafterweise kann dadurch eine Temperatur des Akkupacks außerhalb des zulässigen Betriebstemperaturbereichs des Akkupacks simuliert werden.

In einer alternativen Ausführungsform ist der als Thermistor ausgebildete Temperatursensor mit einem ersten Schalter in Reihe geschaltet. Der erste Schalter ist mit dem ersten Anschluss oder mit dem zweiten Anschluss verbunden. Der erste Schalter weist einen fünften Anschluss zum Verbinden des ersten Schalters mit der ersten Steuerung auf. Der mit dem Thermistor in Reihe geschaltete erste Schalter ermöglicht es, dass der Thermistor in einem geöffneten Zustand des ersten Schalters hochohmig ist. Vorteilhafterweise kann dadurch eine Temperatur des Akkupacks außerhalb des zulässigen Betriebstemperaturbereichs des Akkupacks simuliert werden.

Die oben beschriebenen Eigenschaften, Merkmale und Vorteile dieser Erfindung sowie die Art und Weise, wie diese erreicht werden, sind klarer und deutlicher verständlich im Zusammenhang mit der folgenden Beschreibung der Ausführungsbeispiele, die im Zusammenhang mit den Zeichnungen näher erläutert werden. Dabei zeigen in jeweils schematischer Darstellung:
- Fig. 1: ein erstes System gemäß einer ersten Ausführungsform zum Durchführen eines Verfahrens zum Erkennen von Kontaktierungsfehlern in einem Akkupack;
- Fig. 2: ein zweites System gemäß einer zweiten Ausführungsform zum Durchführen des Verfahrens; und
- Fig. 3: das Verfahren zum Erkennen von Kontaktierungsfehlern in einem Akkupack.

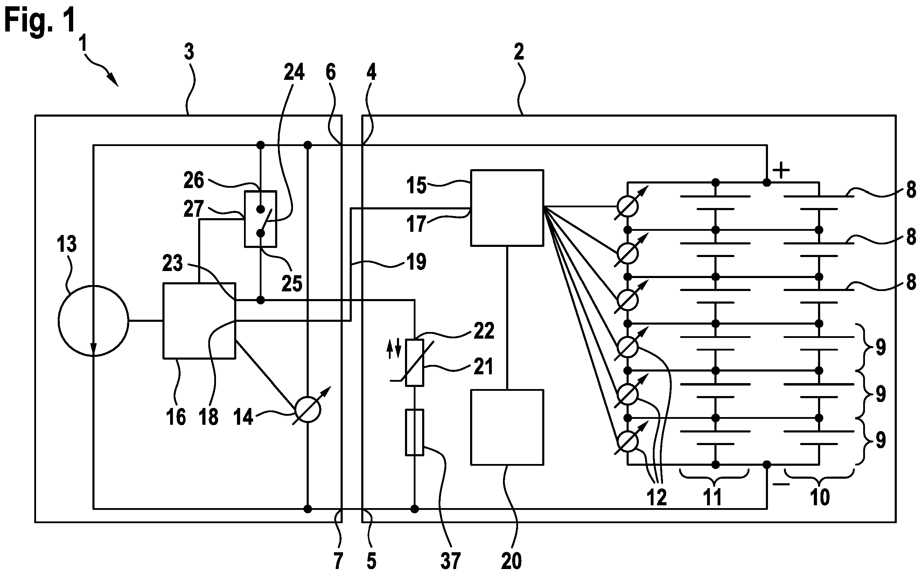

Fig. 1 zeigt schematisch ein erstes System 1 zum Durchführen eines Verfahrens zum Erkennen von Kontaktierungsfehlern in einem Akkupack 2. Neben dem Ackupack 2 weist das erste System 1 ein elektrisches Gerät 3 auf.

Der Akkupack 2 weist einen ersten Anschluss 4 und einen zweiten Anschluss 5 zum Verbinden des Akkupacks 2 mit dem elektrischen Gerät 3 auf. Das elektrische Gerät 3 weist einen sechsten Anschluss 6 und einen siebten Anschluss 7 zum Verbinden des elektrischen Geräts 3 mit dem Akkupack 2 auf. Im ersten System 1 sind der Akkupack 2 und das elektrische Gerät 3 über den ersten Anschluss 4 des Akkupacks 2 und den sechsten Anschluss 6 des elektrischen Geräts 3 und über den zweiten Anschluss 5 des Akkupacks 2 und den siebten Anschluss 7 des elektrischen Geräts 3 miteinander verbunden.

Der Akkupack 2 weist eine Mehrzahl von Akkus 8 auf. Die Akkus 8 können beispielsweise als Lithium-Ionen-Akkus, Blei-Akkus, Nickel-Cadmium-Akkus oder auch als Lithium-Polymer-Akkus ausgebildet sein. In der beispielhaften Darstellung der Fig. 1 weist der Akkupack 2 zwölf Akkus 8 auf. Der Akkupack 2 kann jedoch auch eine andere Anzahl von Akkus 8 aufweisen. Die Akkus 8 sind mittels Zellverbindern miteinander verschaltet, wobei die Zellverbinder selbst der Einfachheit halber in Fig. 1 nicht gezeigt sind. Die Zellverbinder weisen ein Metall auf und werden typischerweise an die Akkus 8 angeschweißt. Grundsätzlich ist es durch eine Reihenschaltung von Akkus 8 möglich, eine Gesamtspannung des Akkupacks 2 zu erhöhen. Durch eine Parallelschaltung von Akkus 8 ist es hingegen möglich, eine Gesamtkapazität des Akkupacks 2 zu erhöhen.

Jeder Akku 8 des Akkupacks 2 ist zumindest mit einem weiteren Akku 8 des Ackupacks 2 parallel geschaltet. In der beispielhaften Darstellung der Fig. 1 sind jeweils zwei Akkus 8 parallel miteinander verschaltet und bilden eine Akkugruppe 9. Beispielhaft sind sechs identisch ausgebildete Akkugruppen 9 in Reihe geschaltet. Eine Akkugruppe 9 kann auch eine beliebige Anzahl parallel miteinander verschalteter Akkus 8 aufweisen. Eine Akkugruppe 9 kann auch miteinander in Reihe geschaltete Akkus 8 aufweisen. Es kann auch eine beliebige Anzahl von Akkugruppen 9 miteinander in Reihe geschaltet sein. Der Akkupack 2 muss auch nicht notwendigerweise ausschließlich identisch ausgebildete Akkugruppen 9 aufweisen. Erforderlich ist lediglich, dass jeder Akku 8 des Akkupacks 2 zumindest mit einem weiteren Akku 8 des Akkupacks 2 parallel geschaltet ist. Das bedeutet, dass der Akkupack 2 zumindest einen ersten Strang 10 und einen zweiten Strang 11 aufweist. Der Akkupack 2 kann jedoch auch mehr als zwei Stränge 10, 11 aufweisen. Würde sich ein Akku 8 eines Stranges 10, 11 elektrisch aus dem Verbund der Akkus 8 lösen, so würde der Akkupack 2 lediglich einen der Stränge 10, 11 aufweisen, da sich in diesem Fall lediglich einer der Stränge 10, 11 ohne Unterbrechung vom Minus- bis zum Pluspol erstrecken würde. Weist der Akkupack 2 also eine Mehrzahl von Strängen 10, 11 auf und löst sich ein Akku 8 innerhalb eines Strangs 10, 11 elektrisch aus dem Verbund der Akkus 8, so kann sich die Anzahl der Stränge 10, 11 des Akkupacks 2 um einen Strang 10, 11 reduzieren.

In der beispielhaften Darstellung der Fig. 1 weist der Akkupack 2 sechs Spannungsmessgeräte 12 auf. Die Spannungsmessgeräte 12 sind mit den Akkus 8 verbunden und dazu ausgebildet, am Akkupack 2 anliegende Spannungen zu erfassen. Jedes Spannungsmessgerät 12 ist dazu ausgebildet, eine an einer Ackugruppe 9 anliegende Spannung zu erfassen. Der Akkupack 2 kann jedoch eine beliebige Anzahl von Spannungsmessgeräten 12 aufweisen. Sind beispielsweise alle Akkus 8 des ersten Strangs 10 in Reihe geschaltet und alle Akkus 8 des zweiten Strangs 11 in Reihe geschaltet und der erste Strang 10 und der zweite Strang 11 sind parallel geschaltet, so kann jeweils ein Spannungsmessgerät 12 mit einem Strang 10, 11 verbunden und dazu ausgebildet sein, eine am jeweiligen Strang 10, 11 anliegende Spannung zu erfassen. Sind alle Akkus 8 einer Akkugruppe 9 parallel miteinander verschaltet, so liegen die Akkus 8 dieser Ackugruppe 9 vorteilhafterweise alle auf einem gemeinsamen elektrischen Potential. Die in Fig. 1 dargestellte Variante der Verschaltung der Akkus 8 bietet also den Vorteil, dass die von den Spannungsmessgeräten 12 erfassten Spannungen, die an den Akkugruppen 9 anliegen, den an den einzelnen Akkus 8 anliegenden Spannungen entsprechen. Die Spannungsmessgeräte 12 können jedoch auch entfallen.

Das elektrische Gerät 3 kann beispielsweise ein Ladegerät sein, mit dem der Ackupack 2 geladen werden kann. Das elektrische Gerät 3 kann jedoch auch ein beliebiges elektrisches Werkzeug sein. Das elektrische Gerät 3 kann beispielsweise ein Akkuschrauber sein, bei dem der Akkupack 2 durch eine Verwendung des Akkuschraubers entladen werden kann. Das elektrische Gerät 3 weist eine Stromquelle 13 oder eine Stromsenke 13 auf. Ist das elektrische Gerät 3 als Ladegerät ausgebildet, so weist das elektrische Gerät 3 die Stromquelle 13 auf. Ist das elektrische Gerät 3 als elektrisches Werkzeug ausgebildet, so weist das elektrische Gerät 3 die Stromsenke 13 auf. Die Stromquelle 13 kann beispielsweise einen Ladestrom für den Akkupack 2 bereitstellen. Die Stromsenke 13 kann einen Entladestrom des Akkupacks 2 verbrauchen. Die Stromquelle 13 oder die Stromsenke 13 ist mit dem sechsten Anschluss 6 und mit dem siebten Anschluss 7 verbunden. Über den ersten Anschluss 4 und den zweiten Anschluss 5 des Akkupacks 2 ist die Stromquelle 13 oder die Stromsenke 13 mit den Akkus 8 des Akkupacks 2 verbunden. In der beispielhaften Darstellung der Fig. 1 liegt der Pluspol am ersten Anschluss 4 und der Minuspol am zweiten Anschluss 5 an, wobei der Plus- und der Minuspol auch miteinander vertauscht sein können.

Das elektrische Gerät 3 weist ein weiteres Spannungsmessgerät 14 auf. Das weitere Spannungsmessgerät 14 ist mit dem sechsten Anschluss 6 und dem siebten Anschluss 7 des elektrischen Geräts 3 verbunden und dazu ausgebildet, eine zwischen dem sechsten Anschluss 6 und dem siebten Anschluss 7 anliegende Spannung zu erfassen. Das weitere Spannungsmessgerät 14 ist also dazu ausgebildet, eine Gesamtspannung des Akkupacks 2 zu erfassen. Das weitere Spannungsmessgerät 14 kann jedoch auch entfallen. Das weitere Spannungsmessgerät 14 des elektrischen Geräts 3 kann dann entfallen, wenn der Ackupack 2 zumindest ein Spannungsmessgerät 12 aufweist. Umgekehrt können die Spannungsmessgeräte 12 des Akkupacks 2 entfallen, wenn das elektrische Gerät 3 das weitere Spannungsmessgerät 14 aufweist. Das erste System 1 weist also zumindest ein Spannungsmessgerät 12 oder das weitere Spannungsmessgerät 14 auf.

Der Akkupack 2 weist eine erste Steuerung 15 auf. Das elektrische Gerät 3 weist eine zweite Steuerung 16 auf. Die erste Steuerung 15 und die zweite Steuerung 16 können beispielsweise als Microcontroller ausgebildet sein. Die erste Steuerung 15 des Akkupacks 2 weist einen dritten Anschluss 17 zum Verbinden der ersten Steuerung 15 mit der zweiten Steuerung 16 auf. Die zweite Steuerung 16 des elektrischen Geräts 3 weist einen achten Anschluss 18 zum Verbinden der zweiten Steuerung 16 mit der ersten Steuerung 15 auf. Die erste Steuerung 15 und die zweite Steuerung 16 sind mittels einer Datenleitung 19 miteinander verbunden, die sich zwischen dem dritten Anschluss 17 der ersten Steuerung 15 und dem achten Anschluss 18 der zweiten Steuerung 16 erstreckt. Das elektrische Gerät 3 und der Akkupack 2 können über die Datenleitung 19 Daten in bidirektionaler Weise miteinander austauschen. Es ist auch möglich, dass die erste Steuerung 15 und die zweite Steuerung 16 drahtlos miteinander kommunizieren. In diesem Fall können der dritte Anschluss 17, der achte Anschluss 18 und die Datenleitung 19 entfallen. Die erste Steuerung 15 des Akkupacks 2 kann auch entfallen. Die erste Steuerung 15 des Akkupacks 2 kann dann entfallen, wenn der Akkupack 2 keine Spannungsmessgeräte 12 aufweist.

Die zweite Steuerung 16 des elektrischen Geräts 3 ist mit der Stromquelle 13 oder der Stromsenke 13 verbunden. Die zweite Steuerung 16 ist dazu ausgebildet, die Stromquelle 13 oder die Stromsenke 13 zu steuern. Ist das elektrische Gerät 3 beispielsweise als Ladegerät ausgebildet, so kann die zweite Steuerung 16 die Stromquelle 13 beispielsweise derart ansteuern, dass die Stromquelle 13 dem Akkupack 2 einen festgelegten Ladestrom zur Verfügung stellt. Ist das elektrische Gerät 3 also als Ladegerät ausgebildet, so kann die zweite Steuerung 16 des elektrischen Geräts 3 auch als Laderegler bezeichnet werden. Ist das elektrische Gerät 3 als elektrisches Werkzeug ausgebildet, so kann die zweite Steuerung 16 beispielsweise einen festgelegten Entladestrom setzen.

Der Akkupack 2 weist einen Temperatursensor 21 auf. Der Temperatursensor 21 ist dazu vorgesehen, eine Temperatur des Akkupacks 2 zu erfassen. Der Temperatursensor 21 kann beispielsweise als Thermistor ausgebildet sein. Der als Thermistor ausgebildete Temperatursensor 21 kann ein Heißleiter oder ein Kaltleiter sein. Beispielhaft ist der Temperatursensor 21 in Fig. 1 als Heißleiter dargestellt. Der Heißleiter weist einen negativen Temperaturkoeffizienten (NTC) auf und verfügt somit in einem wärmeren Zustand über eine besser elektrische Leitfähigkeit als in einem kälteren Zustand. Der Temperatursensor 21 weist einen vierten Anschluss 22 zum Verbinden des Temperatursensors 21 mit der ersten Steuerung 15 oder mit der zweiten Steuerung 16 auf. In der beispielhaften Darstellung der Fig. 1 ist der Temperatursensor 21 mit der zweiten Steuerung 16 verbunden, wobei der vierte Anschluss 22 des Temperatursensors 21 mit einem neunten Anschluss 23 der zweiten Steuerung 16 verbunden ist. Die zweite Steuerung 16 ist dazu ausgebildet, eine Temperatur des Akkupacks 2 anhand eines temperaturabhängigen elektrischen Widerstands des Temperatursensors 21 zu ermitteln. Alternativ kann auch die erste Steuerung 15 den neunten Anschluss 23 zum Verbinden der ersten Steuerung 15 mit dem Temperatursensor 21 aufweisen und dazu ausgebildet sein, die Temperatur des Akkupacks 2 anhand des temperaturabhängigen elektrischen Widerstands des Temperatursensors 21 zu ermitteln. Der Temperatursensor 21 kann auch entfallen.

Der Akkupack 2 weist einen Speicher 20 auf. Der Speicher 20 ist als nichtflüchtiger Speicher ausgebildet und mit der ersten Steuerung 15 des Akkupacks 2 verbunden. Informationen, die der ersten Steuerung 15 bereitgestellt werden, können von der ersten Steuerung 15 im Speicher 20 hinterlegt werden. Die Spannungsmessgeräte 12 des Akkupacks 2 sind mit der ersten Steuerung 15 des Akkupacks 2 verbunden. Dadurch können von den Spannungsmessgeräten 12 ermittelte Spannungen im Speicher 20 hinterlegt werden. Auch die durch das weitere Spannungsmessgerät 14 des elektrischen Geräts 3 ermittelte Gesamtspannung des Akkupacks 2 kann über die zweite Steuerung 16 und über die erste Steuerung 15 im Speicher 20 hinterlegt werden. Dazu ist das weitere Spannungsmessgerät 14 mit der zweiten Steuerung 16 verbunden. Weist der Akkupack 2 keine Spannungsmessgeräte 12 und keine erste Steuerung 15 auf, so ist der Speicher 20 des Akkupacks 2 mit der zweiten Steuerung 16 des elektrischen Geräts 3 verbunden sein.

Die erste Steuerung 15 und die zweite Steuerung 16 sind dazu ausgebildet, empfangene Informationen auszuwerten, sodass auf Grundlage der von den Spannungsmessgeräten 12 und dem weiteren Spannungsmessgerät 14 ermittelten Spannungen Parameter ermittelt werden können, die eine Aussage darüber ermöglichen können, ob Kontaktierungsfehler im Akkupack 2 vorliegen. Die ermittelten Parameter können im Speicher 20 hinterlegt werden.

Bei den Parametern kann es sich beispielsweise um Innenwiderstände der Akkus 8, Innenwiderstände der Akkugruppen 9, einen Innenwiderstand des Akkupacks 2 oder Differenzen zwischen zwei an einer Akkugruppe 9 anliegenden Spannungen handeln. Ferner können auch vorgegebene Innenwiderstände der Akkus 8, der Akkugruppen 9 und des Akkupacks 2 im Speicher hinterlegt sein. Dies ermöglicht beispielsweise einen Vergleich zwischen ermittelten und vorgegebenen Innenwiderständen. Die Steuerungen 15, 16 sind auch dazu ausgebildet, ermittelte Parameter untereinander zu vergleichen. Im Speicher 20 können auch Abhängigkeiten der Innenwiderstände der Akkus 8, der Akkugruppen 9 und des Ackupacks 2 und Abhängigkeiten der an den Akkus 8, an den Akkugruppen 9 und am Akkupack 2 anliegenden Spannungen von der Temperatur des Akkupacks 2, von einer Anzahl der Lade- und der Entladezyklen des Akkupacks 2 und von einem Ladezustand des Akkupacks 2 hinterlegt sein.

Der Speicher 20 ist auch dazu vorgesehen, andere Informationen bezüglich des Akkupacks 2 zu speichern. Die im Speicher 20 hinterlegten Informationen können beispielsweise Informationen über eine Anzahl der Akkus 8 des Akkupacks 2 und ihre Verschaltung, Informationen über die Akkutypen der Akkus 8 und Informationen über eine Ladeschlussspannung und eine Entladeschlussspannung des Akkupacks 2 umfassen. Außerdem können Steuerungsbefehle bezüglich des Akkupacks 2 im Speicher 20 hinterlegt sein. Beispielsweise kann eine Information darüber, dass der Akkupack 2 gesperrt ist, im Speicher 20 hinterlegt sein. Diese Information kann von der ersten Steuerung 15 wieder abgerufen werden und an die zweite Steuerung 16 des elektrischen Geräts 3 übermittelt werden, sodass die zweite Steuerung 16 eine weitere Verwendung des Akkupacks 2 durch entsprechende Steuerungsbefehle an die Stromquelle 13 bzw. die Stromsenke 13 verhindert. Die Information darüber, dass der Akkupack 2 gesperrt werden muss, kann anhand eines von der ersten Steuerung 15 oder der zweiten Steuerung 16 ermittelten und mit einer Vergleichsgröße verglichenen Parameters bestimmt und im Speicher 20 hinterlegt werden.

Das Sperren des Akkupacks 2 kommt beispielsweise dann in Betracht, wenn sich zumindest ein Akku 8 des Akkupacks 2 elektrisch aus dem Verbund der Akkus 8 herausgelöst hat. Dies kann beispielsweise durch mechanische Belastungen beim Einsatz des elektrischen Geräts 3 hervorgerufen werden. Dabei wird eine Schweißstelle zwischen einem Zellverbinder und einem Akku 8 beschädigt. Dies kann beispielsweise dadurch festgestellt werden, dass als Parameter der Innenwiderstand des Akkupacks 2 bestimmt wird und mit dem vorgegebenen Innenwiderstand des Akkupacks 2, der in diesem Fall die Vergleichsgröße ist, verglichen wird. Weicht der bestimmte Innenwiderstand um einen festgelegten Schwellwert vom vorgegebenen Innenwiderstand ab, so kann dies als ein elektrisches Herauslösen zumindest eines Akkus 8 aus dem Akkupack 2 interpretiert werden.

Löst sich beispielsweise ein Akku 8 des ersten Stranges 10 elektrisch aus dem Verbund, so kann sich der Strom nicht mehr symmetrisch auf den ersten Strang 10 und den zweiten Strang 11 verteilen, sondern fließt über einen einzigen Akku 8 des zweiten Strangs 11. Als Folge kann der verbliebene Akku 8 der Akkugruppe 9, aus der sich ein Akku 8 elektrisch gelöst hat, gegebenenfalls nicht mehr innerhalb eines für den Akku 8 vorgegebenen Spezifikationsfensters betrieben werden. Dabei kann es beispielsweise sein, dass der verbliebene Akku 8 nur noch außerhalb eines zulässigen Ladestromwertebereichs betrieben werden kann, wodurch der verbliebene Akku 8 beschädigt werden kann und eine Gefährdung hervorrufen kann. Aus diesem Grund wird im Speicher 20 die Information darüber, dass der Akkupack 2 gesperrt werden muss hinterlegt.

Ein permanentes Sperren des Akkupacks 2 ist besonders vorteilhaft bei unsteten Kontaktierungsfehlern, wenn beispielsweise bei einer zerrütteten Schweißstelle noch ein kraftschlüssiger Kontakt zwischen einem Zellverbinder und einem Akku 8 besteht, der jedoch nicht zuverlässig ist. Es kann auch die Gefahr bestehen, dass es im Fall einer beschädigten Schweißstelle zu einer schädlichen Überhitzung durch eine hochohmige Kontaktierung zwischen einem Akku 8 und einem Zellverbinder infolge der geschädigten Schweißstelle kommt.

Das Sperren des Akkupacks 2 kann auf verschiedene Art und Weise erfolgen. Fig. 1 zeigt ein Beispiel, bei dem der Akkupack 2 dadurch gesperrt werden kann, dass der Temperatursensor 21 derart beeinflusst wird, dass eine Temperatur des Akkupacks 2 außerhalb eines zulässigen Betriebstemperaturbereichs des Akkupacks 2 erfasst und eine weitere Verwendung des Akkupacks 2 von der zweiten Steuerung 16 des elektrischen Geräts 3 verhindert wird. Die Temperatur des Ackupacks 2 wird von der zweiten Steuerung 16 des elektrischen Geräts 3 anhand des temperaturabhängigen elektrischen Widerstands des Temperatursensors 21 erfasst.

Der Akkupack 2 weist eine mit dem als Thermistor ausgebildeten Temperatursensor 21 in Reihe geschaltete Sicherung 37 auf. Die Sicherung 37 kann beispielsweise als Schmelzsicherung oder als ein anderes stromunterbrechendes Bauteil (CID) ausgebildet sein. Die Sicherung 37 kann entweder mit dem ersten Anschluss 4 oder mit dem zweiten Anschluss 5 verbunden sein. Beispielhaft ist in Fig. 1 gezeigt, dass die Sicherung 37 mit dem zweiten Anschluss 5 verbunden ist. Ferner weist das elektrische Gerät 3 einen zweiten Schalter 24 auf. Der zweite Schalter 24 kann beispielsweise als Transistor oder als Relais ausgebildet sein. Der zweite Schalter 24 weist einen zehnten Anschluss 25 zum Verbinden des zweiten Schalters 24 mit dem Temperatursensor 21 auf. Der zweite Schalter 24 weist einen elften Anschluss 26 zum Verbinden des zweiten Schalters 24 mit dem sechsten Anschluss 6 oder mit dem siebten Anschluss 7 auf, wobei der zweite Schalter 24 in Fig. 1 beispielhaft mit dem sechsten Anschluss 6 verbunden ist, da die Sicherung 37 beispielhaft mit dem zweiten Anschluss 5 verbunden ist. Es ist auch möglich, dass der zweite Schalter 24 mit dem siebten Anschluss 7 verbunden ist und, dass die Sicherung 37 mit dem ersten Anschluss 4 verbunden ist. Der zweite Schalter 24 weist einen zwölften Anschluss 27 zum Verbinden des zweiten Schalters 24 mit der ersten Steuerung 15 des Akkupacks 2 oder mit der zweiten Steuerung 16 des elektrischen Geräts 3 auf, wobei in Fig. 1 beispielhaft die Variante gezeigt ist, bei der der zweite Schalter 24 über den zwölften Anschluss 27 mit der zweiten Steuerung 16 des elektrischen Geräts 3 verbunden ist. Beispielhaft wird der zweite Schalter 24 also von der zweiten Steuerung 16 angesteuert. Alternativ kann der zweite Schalter 24 auch von der ersten Steuerung 15 angesteuert werden. In einem geschlossenen Zustand des zweiten Schalters 24 liegt die Gesamtspannung des Akkupacks 2 an der Sicherung 37 an, wodurch die Sicherung 37 durchtrennt werden kann. Bei einer alternativen Variante kann statt der Gesamtspannung des Akkupacks 2 auch eine Netzspannung mittels des zweiten Schalters 24 an die Sicherung 37 angelegt werden. In diesem Fall ist der zweite Schalter 24 nicht mit dem sechsten Anschluss 6 und die Sicherung 37 ist nicht mit dem zweiten Anschluss 5 verbunden, sondern sind in einem separaten Schaltkreis in Reihe angeordnet, der von der Netzspannung beaufschlagt wird. Ist die Sicherung 37 unterbrochen, wird ein hochohmiger Zustand des als Thermistor ausgebildeten Temperatursensors 21 simuliert. Ist der Temperatursensor 21 ein Heißleiter, kann auf diese Weise eine niedrige Temperatur des Akkupacks 2 simuliert werden. Diese niedrige simulierte Temperatur kann außerhalb des zulässigen Betriebstemperaturbereichs des Akkupacks 2 liegen. Typischerweise dürfen Akkupacks 2 in einem Temperaturwertebereich von ca. 0 °C bis 50 °C betrieben werden, damit sie keinen Schaden nehmen. Die Sicherung 37 kann auch entfallen.

Alternativ zur Hochohmigkeit des Temperatursensors 21 kann auch eine Niederohmigkeit des Temperatursensors 21 simuliert werden. Bei dieser Variante entfällt die Sicherung 37, sodass der Temperatursensor 21 an den zweiten Anschluss 5 angeschlossen ist, wenn der zweite Schalter 24 an den sechsten Anschluss 6 angeschlossen ist. In einem geschlossenen Zustand des zweiten Schalters 24 wird der Temperatursensor 21 kurzgeschlossen. Ist der als Thermistor ausgebildete Temperatursensor 21 ein Heißleiter, wird dadurch eine Niederohmigkeit des Temperatursensors 21 simuliert. In diesem Fall kann eine Temperatur des Akkupacks 2 simuliert werden, die über einer maximal zulässigen Temperatur des Akkupacks 2 liegt. Der zweite Schalter 24 kann jedoch auch entfallen.

Ist der Temperatursensor 21 wie in Fig. 1 gezeigt mit der zweiten Steuerung 16 verbunden, kann die zweite Steuerung 16 die Information darüber, dass die Temperatur des Akkupacks 2 außerhalb des zulässigen Betriebstemperaturbereichs liegt, an die erste Steuerung 15 übermitteln und die erste Steuerung 15 kann die Information im Speicher 20 hinterlegen. Diese Information kann von der zweiten Steuerung 16 wieder abgerufen und verwendet werden, um durch entsprechende Steuerungsbefehle an die Stromquelle 13 oder die Stromsenke 13 den Akkupack 2 zu sperren.

Weist der Akkupack 2 keinen Temperatursensor 21 und keine Sicherung 37 auf und weist das elektrische Gerät 3 keinen zweiten Schalter 24 auf, so kann der Akkupack 2 auch dadurch gesperrt werden, dass eine weitere Verwendung des Akkupacks 2 von der zweiten Steuerung 16 verhindert wird, wenn ein bestimmter Parameter von einer Vergleichsgröße um einen festgelegten Schwellwert abweicht und die zweite Steuerung 16 entsprechende Steuerungsbefehle an die Stromquelle 13 oder die Stromsenke 13 weiterleitet.

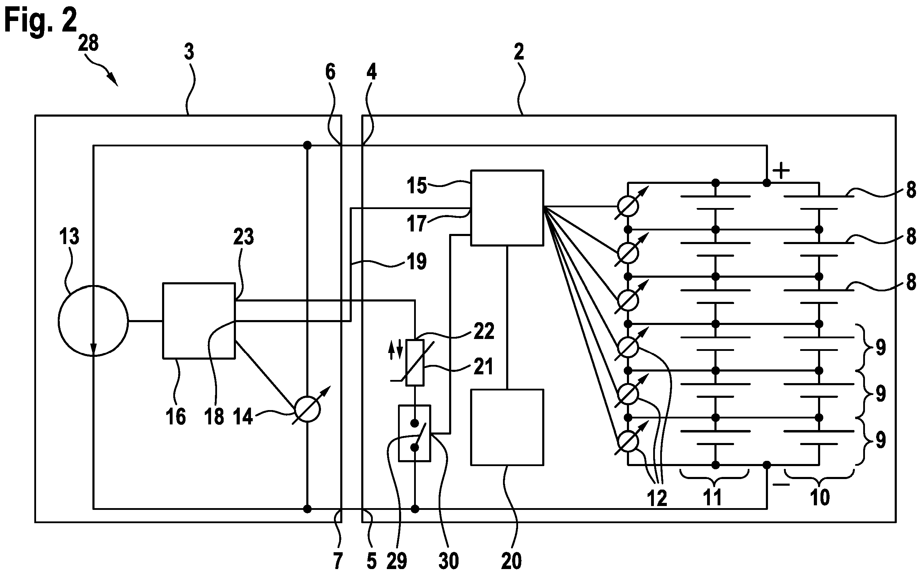

Fig. 2 zeigt schematisch ein zweites System 28 gemäß einer zweiten Ausführungsform zum Durchführen des Verfahrens zum Erkennen von Kontaktierungsfehlern in einem Akkupack 2. Das erste System 1 und das zweite System 28 weisen eine große Ähnlichkeit auf. Ähnlich oder identisch ausgebildete Elemente sind mit denselben Bezugszeichen versehen. Im Folgenden werden lediglich die Unterschiede des zweiten Systems 28 zum ersten System 1 erläutert.

Das zweite System 28 bietet eine weitere Variante zum Simulieren einer außerhalb des zulässigen Betriebstemperaturbereichs liegenden Temperatur des Ackupacks 2. In diesem Fall entfällt die Sicherung 37 des Akkupacks 2 und der zweite Schalter 24 des elektrischen Geräts 3. Stattdessen weist der Akkupack 2 einen ersten Schalter 29 auf, der beispielsweise als Transistor oder Relais ausgebildet sein kann. Der erste Schalter 29 ist mit dem als Thermistor ausgebildeten Temperatursensor 21 in Reihe geschaltet und mit dem zweiten Anschluss 5 verbunden. Alternativ kann der erste Schalter 29 auch mit dem ersten Anschluss 4 verbunden sein. Der erste Schalter 29 weist einen fünften Anschluss 30 zum Verbinden des ersten Schalters 29 mit der ersten Steuerung 15 auf. Der erste Schalter 29 ist mit der ersten Steuerung 15 des Akkupacks 2 verbunden und wird von der ersten Steuerung 15 angesteuert. In einem geöffneten Zustand des ersten Schalters 29 wird eine Hochohmigkeit des Temperatursensors 21 simuliert. Eine Information darüber, dass ein Kontaktierungsfehler im Akkupack 2 vorliegt kann von der ersten Steuerung 15 an die zweite Steuerung 16 übermittelt werden. Diese Information kann auch im Speicher 20 des Akkupacks 2 hinterlegt werden. Ist dies der Fall, so kann die erste Steuerung 15 den ersten Schalter 29 auf Grundlage der im Speicher 20 hinterlegten Information darüber, dass ein Kontaktierungsfehler im Akkupack 2 vorliegt, öffnen und eine Verwendung des Akkupacks 2 durch das elektrische Gerät 3 kann von der zweiten Steuerung 15 verhindert werden. Wird der Akkupack 2 an ein weiteres elektrisches Gerät angeschlossen, so kann die erste Steuerung 15 den ersten Schalter 29 auf Grundlage der im Speicher 20 hinterlegten Information darüber, dass ein Kontaktierungsfehler im Akkupack 2 vorliegt, öffnen und eine Verwendung des Akkupacks 2 durch das weitere elektrische Gerät kann von einer weiteren Steuerung des weiteren elektrischen Geräts verhindert werden. Der erste Schalter 29 kann auch entfallen.

Weist der Akkupack 2 keinen Temperatursensor 21 und keinen ersten Schalter 29 auf, so kann der Akkupack 2 auch dadurch gesperrt werden, dass eine weitere Verwendung des Akkupacks 2 von der zweiten Steuerung 16 des elektrischen Geräts 3 verhindert wird, wenn ein bestimmter Parameter von einer Vergleichsgröße um einen festgelegten Schwellwert abweicht und die zweite Steuerung 16 entsprechende Steuerungsbefehle an die Stromquelle 13 oder die Stromsenke 13 weiterleitet.

Der Akkupack 2 des ersten Systems 1 oder des zweiten Systems 28 muss nicht notwendigerweise dauerhaft gesperrt werden, wenn sich die Anzahl der Stränge 10, 11 des Akkupacks 2 beispielsweise aufgrund eines elektrischen Herauslösens eines Akkus 8 reduziert hat. Alternativ kann der Akkupack 2 auch eingeschränkt verwendet werden, wenn der Akkupack 2 trotz der geringeren Anzahl an Strängen 10, 11 beispielsweise innerhalb eines angepassten Ladestromwertebereichs betrieben werden kann. In diesem Fall erfolgt nach dem Sperren des Akkupacks 2 aus Sicherheitsgründen ein Entsperren des Akkupacks 2, wenn der Akkupack 2 sich gegenüber dem elektrischen Gerät 3 als weniger-strängig ausweist. Eine Information darüber, dass der Akkupack 2 weniger-strängig ist, kann anhand eines von der ersten Steuerung 15 oder der zweiten Steuerung 16 ermittelten und mit einer Vergleichsgröße verglichenen Parameters bestimmt und im Speicher 20 hinterlegt werden. Diese Information kann von der ersten Steuerung 15 wieder abgerufen werden und an die zweite Steuerung 16 des elektrischen Geräts 3 übermittelt werden, sodass die zweite Steuerung 16 eine Verwendung des Akkupacks 2 durch entsprechende Steuerungsbefehle an die Stromquelle 13 bzw. die Stromsenke 13 ermöglicht. Dann kann beispielsweise ein Lade- oder ein Entladestrom angepasst werden, sodass ein Betrieb des Akkupacks 2 mit angepasstem Lade- oder Entladestrom, beispielsweise mit einem reduzierten Lade- oder Entladestrom, möglich ist.

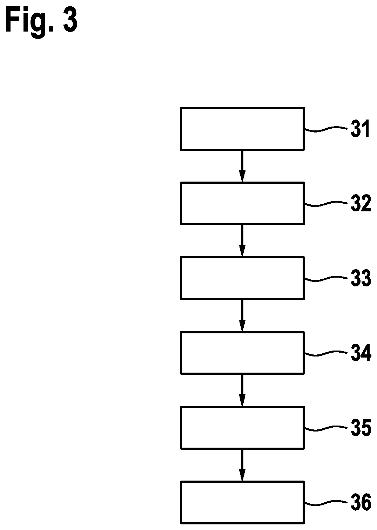

Fig. 3 zeigt schematisch Verfahrensschritte des Verfahrens zum Erkennen von Kontaktierungsfehlern im Akkupack 2, wobei jeder Akku 8 des Akkupacks 2 zumindest mit einem weiteren Akku 8 des Akkupacks 2 parallel geschaltet ist. Das Verfahren kann mittels des ersten Systems 1 oder mittels des zweiten Systems 28 durchgeführt werden.

In einem ersten Verfahrensschritt 31 wird zumindest ein Strom an den Akkupack 2 angelegt. Der Strom kann beispielsweise ein Lade- oder ein Entladestrom sein, der von der Stromquelle 13 oder der Stromsenke 13 bereitgestellt bzw. verbraucht wird.

In einem zweiten Verfahrensschritt 32 wird zumindest eine am Akkupack 2 anliegende Spannung in Abhängigkeit vom angelegten Strom ermittelt. Bei der Spannung kann es sich beispielsweise um die vom weiteren Spannungsmessgerät 14 ermittelte Gesamtspannung des Akkupacks 2 oder um eine von einem Spannungsmessgerät 12 des Akkupacks 2 ermittelte, an den Akkugruppen 9 anliegende Spannung handeln.

In einem dritten Verfahrensschritt 33 wird zumindest ein Parameter auf Grundlage der ermittelten Spannung bestimmt. In einem vierten Verfahrensschritt 34 wird der Parameter mit der Vergleichsgröße verglichen.

Der Parameter kann beispielsweise der Innenwiderstand des Akkupacks 2 sein. In diesem Fall ist die Vergleichsgröße ein vorgegebener Innenwiderstand des Akkupacks 2. Die ermittelte Spannung wird vom weiteren Spannungsmessgerät 14 des elektrischen Geräts 3 an die zweite Steuerung 16 weitergeleitet. Die zweite Steuerung 16 ermittelt den Innenwiderstand des Akkupacks 2 auf Grundlage der ermittelten Spannung und vergleicht den ermittelten Innenwiderstand mit dem vorgegebenen Innenwiderstand. Der vorgegebene Innenwiderstand des Ackupacks 2 kann beispielsweise im Speicher 20 hinterlegt sein. Der vorgegebene Innenwiderstand des Akkupacks 2 kann auch über eine digitale Schnittstelle des Akkupacks 2 oder des elektrischen Geräts 3, die in Fig. 1 und Fig. 2 nicht gezeigt ist, der zweiten Steuerung 16 bereitgestellt werden. Der vorgegebene Innenwiderstand des Akkupacks 2 kann jedoch auch in Form eines Kodierwiderstands im Akkupack 2 hinterlegt sein. In diesem Fall wird der Kodierwiderstand vom elektrischen Gerät 3 mittels in Fig. 1 und Fig. 2 nicht dargestellten Mitteln gemessen.

Ist der Akkupack 2 zumindest aus zwei identischen Akkugruppen 9 gebildet, kann der Parameter auch ein Widerstand einer ersten Akkugruppe 9 und die Vergleichsgröße ein Innenwiderstand einer zweiten Akkugruppe 9 sein. In diesem Fall werden die Spannungen von den Spannungsmessgeräten 12 des Ackupacks 2 ermittelt und der ersten Steuerung 15 des Akkupacks 2 bereitgestellt. Die erste Steuerung 15 ermittelt die Innenwiderstände der Akkugruppen 9 auf Grundlage der ermittelten Spannungen und vergleicht die ermittelten Innenwiderstände mit vorgegebenen Innenwiderständen der Akkugruppen 9, die im Speicher 20 hinterlegt sind oder über die Schnittstelle bereitgestellt wurden. Bei dieser Variante des Verfahrens werden also die Innwiderstände der einzelnen Ackugruppen 9 untereinander verglichen.

Beim Bestimmen eines Innenwiderstandes ist es von Vorteil, wenn mehr als nur ein Strom an den Akkupack 2 angelegt wird und, wenn mehr als nur eine am Ackupack 2 anliegende Spannung in Abhängigkeit von den angelegten Strömen ermittelt wird. Dies kann eine Genauigkeit des Bestimmens des Innenwiderstands verbessern. Ein erster Strom kann dabei auch 0 Ampere betragen. In diesem Fall wird eine Leerlaufspannung ermittelt. Vorteilhafterweise kann es ausreichen, lediglich eine Spannung in Abhängigkeit von einem angelegten Strom zu ermitteln, um einen Innenwiderstand zu ermitteln, der mit einem vorgegebenen Innenwiderstand in guter Übereinstimmung ist. Dies ist beispielsweise dann der Fall wenn eine Temperatur, ein Ladezustand und eine Anzahl von Lade- und Entladezyklen bekannt sind und beim Vergleichen des ermittelten Innenwiderstands mit dem vorgegebenem Innenwiderstand berücksichtigt werden.

Eine weitere Möglichkeit besteht darin, dass bei einem Akkupack 2, das zumindest aus zwei identischen Akkugruppen 9 gebildet ist, als Parameter eine Differenz zwischen zwei an einer ersten Akkugruppe anliegenden Spannungen bestimmt wird, während die Vergleichsgröße eine Differenz zwischen zwei an einer zweiten Akkugruppe 9 anliegenden Spannungen ist. In diesem Fall werden also die an den Akkugruppen 9 anliegenden Spannungen von der ersten Steuerung 15 miteinander verglichen. Dabei kann es sich um Ladespannungen oder Entladespannungen handeln, die an den Akkugruppen 9 anliegen.

Das Erfassen der Temperatur des Akkupacks 2 mittels des Temperatursensors 21 bietet den Vorteil, dass eine Temperaturabhängigkeit des Parameters beim Vergleichen des Parameters mit der Vergleichsgröße berücksichtigt werden kann. Beispielsweise kann eine Temperaturabhängigkeit des Innenwiderstands des Akkupacks 2 oder der Akkugruppen 9 beim Vergleichen des ermittelten Innenwiderstands mit dem vorgegebenen Innenwiderstand berücksichtigt werden. Diese Temperaturabhängigkeit kann beispielsweise im Speicher 20 hinterlegt sein oder über die Schnittstelle bereitgestellt werden. Grundsätzlich gilt, dass der Innenwiderstand eines Akkus 8 mit zunehmender Temperatur abnimmt. Die Ladespannung nimmt bei zunehmender Temperatur ab.

Ferner ist es von Vorteil, Alterungsprozesse des Akkupacks 2 beim Vergleichen des Parameters mit der Vergleichsgröße zu berücksichtigen. Dies kann beispielsweise dadurch erfolgen, dass eine Anzahl von Lade- und Entladezyklen des Akkupacks 2 erfasst wird, die mit einem Alter des Akkupacks 2 korreliert. Die Anzahl der Lade- und Entladezyklen des Akkupacks 2 kann von der ersten Steuerung 15 oder von der zweiten Steuerung 16 erfasst und beim Vergleichen des Parameters mit der Vergleichsgröße berücksichtigt werden. Eine Abhängigkeit des Parameters von der Anzahl der Lade- und Entladezyklen kann beispielsweise im Speicher 20 hinterlegt sein oder über die Schnittstelle bereitgestellt werden. Der Innenwiderstand eines Akkus 8 nimmt mit einer zunehmenden Anzahl von Lade- und Entladezyklen zu. Die Ladespannung nimmt mit einer zunehmenden Anzahl von Lade- und Entladezyklen ab.

Weiter ist es vorteilhaft, einen Ladezustand des Akkupacks 2 zu erfassen und eine Abhängigkeit des Parameters vom Ladezustand des Akkupacks 2 beim Vergleichen des Parameters mit der Vergleichsgröße zu berücksichtigen. Die Abhängigkeit des Parameters vom Ladezustand kann im Speicher 20 hinterlegt sein oder über die Schnittstelle bereitgestellt werden. Der Innenwiderstand eines Ackus 8 sinkt mit zunehmendem Ladezustand, während die Ladespannung mit zunehmendem Ladezustand steigt.

In einem optionalen fünften Verfahrensschritt 35 erfolgt das Sperren des Akkupacks 2, wenn der Parameter um einen festgelegten Schwellwert von der Vergleichsgröße abweicht. Beim Überprüfen, ob der Parameter um den festgelegten Schwellwert von der Vergleichsgröße abweicht, wird die Abhängigkeit des Parameters von der Temperatur, von der Anzahl der Lade- und Entladezyklen und vom Ladezustand des Akkupacks 2 berücksichtigt. Das Sperren des Akkupacks 2 kann beispielsweise dadurch erfolgen, dass der Temperatursensor 21 derart beeinflusst wird, dass eine Temperatur des Akkupacks 2 außerhalb des zulässigen Betriebstemperaturbereichs des Akkupacks 2 erfasst und die weitere Verwendung des Akkupacks 2 von der zweiten Steuerung 16 des elektrischen Geräts 3 verhindert wird. Ist der Temperatursensor 21 als Thermistor ausgebildet ist, kann das Beeinflussen des Temperatursensors 21 im Rahmen des Sperrens des Akkupacks 2 des ersten Systems 1 dadurch erfolgen, dass die mit dem Temperatursensor 21 in Reihe geschaltete Sicherung 37 mit einer für die Sicherung 37 überkritischen Spannung beaufschlagt wird, indem der zweite Schalter 24 geschlossen wird. Alternativ kann der als Thermistor ausgebildete Temperatursensor 21 durch Schließen des zweiten Schalters 24 kurzgeschlossen werden, wenn keine Sicherung 37 vorhanden ist. Das Beeinflussen des als Thermistor ausgebildeten Temperatursensors 21 kann im Rahmen des Sperrens des Akkupacks 2 des zweiten Systems 28 dadurch erfolgen, dass der mit dem Temperatursensor 21 in Reihe geschalteter erster Schalter 29 geöffnet wird.

In einem optionalen sechsten Verfahrensschritt 36 erfolgt das Entsperren des Akkupacks 2. Das Entsperren des Akkupacks 2 erfolgt dadurch, dass der Temperatursensor 21 derart beeinflusst wird, dass eine Temperatur des Akkupacks 2 innerhalb des zulässigen Betriebstemperaturbereichs des Akkupacks 2 erfasst und die weitere Verwendung des Akkupacks 2 von der zweiten Steuerung 16 des elektrischen Geräts 3 ermöglicht wird. Das Beeinflussen des Temperatursensors 21 im Rahmen des Entsperrens des Akkupacks 2 des zweiten Systems 28 kann dadurch erfolgen, dass der erste Schalter 29 wieder geschlossen wird, nachdem er im Rahmen des Sperrens des Akkupacks 2 geöffnet wurde. Das Beeinflussen des Temperatursensors 21 im Rahmen des Entsperrens des Akkupacks 2 des ersten Systems 1 kann dadurch erfolgen, dass der zweite Schalter 24 geöffnet wird, falls der Temperatursensor 21 zuvor durch das Schließen des zweiten Schalters 24 niederohmig geschaltet wurde. In diesem Fall weist der Akkupack 2 des ersten Systems 1 keine Sicherung 37 auf. Ist die Sicherung 37 vorhanden, so muss diese ersetzt werden, wenn sie zuvor durchtrennt wurde und der zweite Schalter 24 muss in einen geöffneten Zustand versetzt werden, um den Akkupack 2 wieder zu entsperren.

Die vorliegende Erfindung wurde anhand der bevorzugten Ausführungsbeispiele näher illustriert und beschrieben. Dennoch ist die Erfindung nicht auf die offenbarten Beispiele beschränkt.

## Patentansprüche

1. Verfahren zum Erkennen von Kontaktierungsfehlern in einem Akkupack (2), wobei jeder Akku (8) des Akkupacks (2) zumindest mit einem weiteren Akku (8) des Akkupacks (2) parallel geschaltet ist,
wobei das Verfahren folgende Verfahrensschritte aufweist:
- Anlegen zumindest eines Stroms an den Akkupack (2),
- Ermitteln zumindest einer am Akkupack (2) anliegenden Spannung in Abhängigkeit vom angelegten Strom,
- Bestimmen zumindest eines Parameters auf Grundlage der ermittelten Spannung,
- Vergleichen des Parameters mit einer Vergleichsgröße,
**gekennzeichnet durch** folgende Verfahrensschritte:
- Sperren des Akkupacks (2), wenn der Parameter um einen festgelegten Schwellwert von der Vergleichsgröße abweicht,
wobei das Sperren des Akkupacks (2) dadurch erfolgt, dass ein Temperatursensor (21) des Akkupacks (2) derart beeinflusst wird, dass eine Temperatur des Akkupacks (2) außerhalb eines zulässigen Betriebstemperaturbereichs des Ackupacks (2) erfasst wird und eine weitere Verwendung des Akkupacks (2) von einer Steuerung (16) verhindert wird.

2. Verfahren gemäß Anspruch 1,
wobei der Temperatursensor (21) als Thermistor ausgebildet ist,
wobei das Beeinflussen des Temperatursensors (21) im Rahmen des Sperrens des Akkupacks (2) dadurch erfolgt, dass eine mit dem Temperatursensor (21) in Reihe geschaltete Sicherung (37) mit einer für die Sicherung (37) überkritischen Spannung beaufschlagt wird.

3. Verfahren gemäß Anspruch 1,
wobei der Temperatursensor (21) als Thermistor ausgebildet ist,
wobei das Beeinflussen des Temperatursensors (21) im Rahmen des Sperrens des Akkupacks (2) dadurch erfolgt, dass ein mit dem Temperatursensor (21) in Reihe geschalteter erster Schalter (29) geöffnet wird.

4. Verfahren gemäß Anspruch 1 oder 3 mit folgendem weiteren Verfahrensschritt:
- Entsperren des Akkupacks (2),
wobei das Entsperren des Akkupacks (2) dadurch erfolgt, dass der Temperatursensor (21) derart beeinflusst wird, dass eine Temperatur des Akkupacks (2) innerhalb des zulässigen Betriebstemperaturbereichs des Akkupacks (2) erfasst wird und die weitere Verwendung des Akkupacks (2) von der Steuerung (16) ermöglicht wird.

5. Verfahren gemäß Anspruch 3 und 4,
wobei das Beeinflussen des Temperatursensors (21) im Rahmen des Entsperrens des Akkupacks (2) durch Schließen des ersten Schalters (29) erfolgt.

6. Akkupack (2)
mit einer Mehrzahl von Akkus (8),
wobei jeder Akku (8) des Akkupacks (2) zumindest mit einem weiteren Akku (8) des Akkupacks (2) parallel geschaltet ist,
wobei der Akkupack (2) einen ersten Anschluss (4) und einen zweiten Anschluss (5) zum Verbinden des Akkupacks (2) mit einem elektrischen Gerät (3) aufweist, wobei der Akkupack (2) zumindest ein Spannungsmessgerät (12), eine erste Steuerung (15), einen Speicher (20) und einen Temperatursensor (21) aufweist, wobei die erste Steuerung (15) einen dritten Anschluss (17) zum Verbinden der ersten Steuerung (15) mit einer zweiten Steuerung (16) aufweist,
wobei die erste Steuerung (15) mit dem Spannungsmessgerät (12) und mit dem Speicher (20) verbunden ist,
wobei der Temperatursensor (21) dazu vorgesehen ist, eine Temperatur des Ackupacks (2) zu erfassen,
wobei der Temperatursensor (21) einen vierten Anschluss (22) zum Verbinden des Temperatursensors (21) mit der ersten Steuerung (15) oder mit der zweiten Steuerung (16) aufweist,
wobei das Spannungsmessgerät (12) dazu ausgebildet ist, eine am Akkupack (2) anliegende Spannung zu erfassen,
**dadurch gekennzeichnet, dass** der Temperatursensor (21) dazu vorgesehen ist, derart beeinflusst zu werden, dass eine Temperatur des Akkupacks (2) außerhalb eines zulässigen Betriebstemperaturbereichs des Akkupacks (2) erfasst wird und eine weitere Verwendung des Akkupacks (2) von der zweiten Steuerung (16) verhindert wird, wodurch der Akkupack (2) gesperrt werden kann.

7. Akkupack (2) gemäß Anspruch 6,
wobei der Temperatursensor (21) als Thermistor ausgebildet ist,
wobei der Akkupack (2) eine mit dem Thermistor in Reihe geschaltete Sicherung (37) aufweist,
wobei die Sicherung (37) mit dem ersten Anschluss (4) oder mit dem zweiten Anschluss (5) verbunden ist.

8. Akkupack (2) gemäß Anspruch 6,
wobei der Temperatursensor (21) als Thermistor ausgebildet ist,
wobei der Akkupack (2) einen mit dem Thermistor in Reihe geschalteten ersten Schalter (29) aufweist,
wobei der erste Schalter (29) mit dem ersten Anschluss (4) oder mit dem zweiten Anschluss (5) verbunden ist,
wobei der erste Schalter (29) einen fünften Anschluss (30) zum Verbinden des ersten Schalters (29) mit der ersten Steuerung (15) aufweist.

## Claims

1. Method for detecting contacting faults in a rechargeable battery pack (2),
wherein each rechargeable battery (8) of the rechargeable battery pack (2) is connected in parallel at least with a further rechargeable battery (8) of the rechargeable battery pack (2),
wherein the method includes the following method steps:
- applying at least one current to the rechargeable battery pack (2),
- ascertaining at least one voltage present at the rechargeable battery pack (2) based on the applied current,
- determining at least one parameter on the basis of the ascertained voltage,
- comparing the parameter with a comparison variable,
**characterized by** the following method steps:
- blocking the rechargeable battery pack (2) if the parameter deviates from the comparison variable by a specified threshold value,
wherein the rechargeable battery pack (2) is blocked by a temperature sensor (21) of the rechargeable battery pack (2) being influenced in such a way that a temperature of the rechargeable battery pack (2) outside of a permissible operating temperature range of the rechargeable battery pack (2) is recorded and further use of the rechargeable battery pack (2) is prevented by a controller (16).

2. Method according to Claim 1,
wherein the temperature sensor (21) is in the form of a thermistor,
wherein, in the course of blocking the rechargeable battery pack (2), the temperature sensor (21) is influenced by a voltage, which is supercritical for the fuse (37), being applied to a fuse (37) connected in series with the temperature sensor (21).

3. Method according to Claim 1,
wherein the temperature sensor (21) is in the form of a thermistor,
wherein, in the course of blocking the rechargeable battery pack (2), the temperature sensor (21) is influenced by a first switch (29), which is connected in series with the temperature sensor (21), being opened.

4. Method according to Claim 1 or 3 having the following further method step:
- unblocking the rechargeable battery pack (2),
wherein the rechargeable battery pack (2) is unblocked by the temperature sensor (21) being influenced in such a way that a temperature of the rechargeable battery pack (2) within the permissible operating temperature range of the rechargeable battery pack (2) is recorded and further use of the rechargeable battery pack (2) is enabled by the controller (16).

5. Method according to Claims 3 and 4,
wherein, in the course of unblocking the rechargeable battery pack (2), the temperature sensor (21) is influenced by the first switch (29) being closed.

6. Rechargeable battery pack (2)
having a plurality of rechargeable batteries (8),
wherein each rechargeable battery (8) of the rechargeable battery pack (2) is connected in parallel at least with a further rechargeable battery (8) of the rechargeable battery pack (2),
wherein the rechargeable battery pack (2) has a first connection (4) and a second connection (5) for connecting the rechargeable battery pack (2) to an electrical device (3),
wherein the rechargeable battery pack (2) has at least one voltmeter (12), a first controller (15), a memory (20) and a temperature sensor (21),
wherein the first controller (15) has a third connection (17) for connecting the first controller (15) to a second controller (16),
wherein the first controller (15) is connected to the voltmeter (12) and to the memory (20),
wherein the temperature sensor (21) is provided to record a temperature of the rechargeable battery pack (2),
wherein the temperature sensor (21) has a fourth connection (22) for connecting the temperature sensor (21) to the first controller (15) or to the second controller (16),
wherein the voltmeter (12) is designed to record a voltage present at the rechargeable battery pack (2),
**characterized in that** the temperature sensor (21) is provided to be influenced in such a way that a temperature of the rechargeable battery pack (2) outside of a permissible operating temperature range of the rechargeable battery pack (2) is recorded and further use of the rechargeable battery pack (2) is prevented by the second controller (16), as a result of which the rechargeable battery pack (2) may be blocked.

7. Rechargeable battery pack (2) according to Claim 6,
wherein the temperature sensor (21) is in the form of a thermistor,
wherein the rechargeable battery pack (2) has a fuse (37) connected in series with the thermistor,
wherein the fuse (37) is connected to the first connection (4) or to the second connection (5).

8. Rechargeable battery pack (2) according to Claim 6,
wherein the temperature sensor (21) is in the form of a thermistor,
wherein the rechargeable battery pack (2) has a first switch (29) connected in series with the thermistor,
wherein the first switch (29) is connected to the first connection (4) or to the second connection (5),
wherein the first switch (29) has a fifth connection (30) for connecting the first switch (29) to the first controller (15).

## Revendications

1. Procédé de détection de défauts de contact dans un bloc d'accumulateurs (2),
chaque accumulateur (8) du bloc d'accumulateurs (2) étant monté en parallèle avec au moins un autre accumulateur (8) du bloc d'accumulateurs (2),
le procédé comprenant les étapes de procédé suivantes :
- l'application d'au moins un courant au bloc d'accumulateurs (2),
- la détermination d'au moins une tension appliquée au bloc d'accumulateurs (2) en fonction du courant appliqué,
- la détermination d'au moins un paramètre sur la base de la tension déterminée,
- la comparaison du paramètre avec une grandeur de comparaison, **caractérisé par** les étapes de procédé suivantes :
- le verrouillage du bloc d'accumulateurs (2) lorsque le paramètre s'écarte de la grandeur de comparaison d'une valeur de seuil spécifiée,
- le verrouillage du bloc d'accumulateurs (2) s'effectuant en faisant en sorte qu'un capteur de température (21) du bloc d'accumulateurs (2) soit influencé de telle sorte qu'une température du bloc d'accumulateurs (2) se situant en dehors d'une plage de température de fonctionnement admissible du bloc d'accumulateurs (2) soit détectée et qu'une utilisation ultérieure du bloc d'accumulateurs (2) soit empêchée par une unité de commande (16).

2. Procédé selon la revendication 1,
le capteur de température (21) étant conçu sous forme de thermistance,
l'influence sur le capteur de température (21) dans le cadre du verrouillage du bloc d'accumulateurs (2) s'effectuant en appliquant à un fusible (37) monté en série avec le capteur de température (21) une tension supercritique pour le fusible (37).

3. Procédé selon la revendication 1,
le capteur de température (21) étant conçu sous forme de thermistance,
l'influence sur le capteur de température (21) dans le cadre du verrouillage du bloc d'accumulateurs (2) s'effectuant en ouvrant un premier commutateur (29) monté en série avec le capteur de température (21).

4. Procédé selon la revendication 1 ou 3, comprenant l'étape de procédé supplémentaire suivante :
- le déverrouillage du bloc d'accumulateurs (2),
- le déverrouillage du bloc d'accumulateurs (2) s'effectuant en faisant en sorte que le capteur de température (21) soit influencé de telle sorte qu'une température du bloc d'accumulateurs (2) se situant à l'intérieur de la plage de température de fonctionnement admissible du bloc d'accumulateurs (2) soit détectée et qu'une utilisation ultérieure du bloc d'accumulateurs (2) soit permise par l'unité de commande (16).

5. Procédé selon la revendication 3 ou 4,
l'influence sur le capteur de température (21) dans le cadre du déverrouillage du bloc d'accumulateurs (2) s'effectuant en fermant le premier commutateur (29).

6. Bloc d'accumulateurs (2)
comprenant une pluralité d'accumulateurs (8),
chaque accumulateur (8) du bloc d'accumulateurs (2) étant monté en parallèle avec au moins un autre accumulateur (8) du bloc d'accumulateurs (2),
le bloc d'accumulateurs (2) comprenant une première borne (4) et une deuxième borne (5) pour connecter le bloc d'accumulateurs (2) à un appareil électrique (3),
le bloc d'accumulateurs (2) comprenant au moins un voltmètre (12), une première unité de commande (15), une mémoire (20) et un capteur de température (21),
la première unité de commande (15) comprenant une troisième borne (17) pour connecter la première unité de commande (15) à une deuxième unité de commande (16),
la première unité de commande (15) étant connectée au voltmètre (12) et à la mémoire (20),
le capteur de température (21) étant conçu pour détecter une température du bloc d'accumulateurs (2),
le capteur de température (21) comprenant une quatrième borne (22) pour connecter le capteur de température (21) à la première unité de commande (15) ou à la deuxième unité de commande (16),
le voltmètre (12) étant conçu pour détecter une tension appliquée au bloc d'accumulateurs (2),
**caractérisé en ce que** le capteur de température (21) est conçu pour être influencé de telle sorte qu'une température du bloc d'accumulateurs (2) se situant en dehors d'une plage de température de fonctionnement admissible du bloc d'accumulateurs (2) soit détectée et qu'une utilisation ultérieure du bloc d'accumulateurs (2) soit empêchée par la deuxième unité de commande (16), ce qui permet de verrouiller le bloc d'accumulateurs (2).

7. Bloc d'accumulateurs (2) selon la revendication 6,
le capteur de température (21) étant conçu sous forme de thermistance,
le bloc d'accumulateurs (2) comprenant un fusible (37) monté en série avec la thermistance,
le fusible (37) étant connecté à la première borne (4) ou à la deuxième borne (5).

8. Bloc d'accumulateurs (2) selon la revendication 6,
le capteur de température (21) étant conçu sous forme de thermistance,
le bloc d'accumulateurs (2) comprenant un commutateur (29) monté en série avec la thermistance,
le commutateur (29) étant connecté à la première borne (4) ou à la deuxième borne (5).
le premier commutateur (29) comprenant une cinquième borne (30) pour connecter le premier commutateur (29) à la première unité de commande (15).
